(19) Europäisches Patentamt

European Patent Office

Office européen des brevets

(11) **EP 4 611 497 A1**

(12) **EUROPEAN PATENT APPLICATION**
published in accordance with Art. 153(4) EPC

(43) Date of publication:
**03.09.2025 Bulletin 2025/36**

(21) Application number: **23882282.9**

(22) Date of filing: **15.09.2023**

(51) International Patent Classification (IPC):
**H05K 9/00** (2006.01)  **B32B 15/08** (2006.01)
**H01Q 1/52** (2006.01)

(52) Cooperative Patent Classification (CPC):
**B32B 15/08; H01Q 1/52; H05K 9/00**

(86) International application number:
**PCT/JP2023/033800**

(87) International publication number:
**WO 2024/090069 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.10.2022 JP 2022171776**

(71) Applicant: **JX Advanced Metals Corporation
Tokyo 105-8417 (JP)**

(72) Inventor: **YAMAMOTO,Yukito
Hitachi-shi, Ibaraki 317-0056 (JP)**

(74) Representative: **Mewburn Ellis LLP
Aurora Building
Counterslip
Bristol BS1 6BX (GB)**

(54) **METAL RESIN COMPOSITE ELECTROMAGNETIC SHIELDING MATERIAL**

(57)  A metal-resin composite electromagnetic shielding material having high formability is provided. A metal resin composite electromagnetic shielding material includes N (where N is an integer of 1 or more) metal layers and M (where M is an integer of 1 or more) resin layers laminated together, wherein a VFL (Value of Forming Limit) satisfies VFL > 0.24.

$R_d = 2$

$R_f = 2,4,6$

$D = 22.5$

Dimensions: mm

FIG. 1

# EP 4 611 497 A1

## Description

### FIELD OF THE INVENTION

The present invention relates to a metal resin composite electromagnetic shielding material. In particular, the present invention relates to a metal resin composite electromagnetic shielding material that can be used as a covering or exterior material for electric and electronic devices.

### BACKGROUND OF THE INVENTION

In recent years, interest in global environmental issues has been growing worldwide, and environmentally friendly automobiles equipped with secondary batteries, such as electric automobiles and hybrid automobiles, are becoming more widespread. Many of these automobiles use a system in which direct current generated by an on-board secondary battery is converted into alternating current via an inverter, and the necessary power is then supplied to an AC motor to obtain driving force. Electromagnetic waves are generated due to the switching operation of the inverter or the like. Since electromagnetic waves can cause reception problems for on-board audio equipment, wireless equipment, or the like, measures have been taken to shield the electromagnetic waves by housing the inverter or the battery, motor, and the like together with the inverter in a metal case.

However, metallic electromagnetic shielding materials have low formability and, being made of metal, also have the problem of weight. Accordingly, there has been proposed a resin composition for insert molding containing a resin and an electromagnetic wave shielding filler (Patent Literature 1: Japanese Patent Application Publication No. 2021-55113), a method for insert-molding a mesh-like electromagnetic shielding body having a flat case shape formed of a mesh metal body and having a central part of the case body and a folded side part around the central part by folding the case body, in a mold (Patent Literature 2: Japanese Patent No. 4811245), and an electromagnetic wave shielding fabric characterized by being woven with a blended yarn formed by Z-twisting and/or S-twisting a metal wire with one or more ordinary spinnable fibers (Patent Literature 3: Japanese Patent Application Publication No.2011-179162).

### PRIOR ART

Patent Literature

[Patent Literature 1] Japanese Patent Application Publication No. 2021-55113

[Patent Literature 2] Japanese Patent No. 4811245

[Patent Literature 1] Japanese Patent Application Publication No. 2011-179162

### SUMMARY OF THE INVENTION

However, when using a resin mixed with a conductive filler, the shielding performance per thickness is poor, and a greater thickness is required to obtain a high shielding performance in the magnetic field shield. Furthermore, in the case of insert molding using a mesh shielding body or electromagnetic wave shielding fabric, there are problems in that gaps are formed in the formed body, reducing the shielding performance at the four corners, and there is also the disadvantage that the effectiveness of shielding magnetic fields is reduced. Therefore, a method for improving formability using an approach different from that of conventional techniques is required.

Metal foils (metal layers) such as copper foils used in electromagnetic shielding materials generally have a thickness of several $\mu$m to several tens of $\mu$m, and therefore are prone to cracking when laminated with a resin film and formed. Therefore, it is important to suppress cracking and improve formability.

Metal resin composite materials have high formability and can be formed into complex shapes, but when the forming process is massive, the metal layer inside may crack during forming. Large cracks in the metal layer can lead to a decrease in shielding properties, so this needs to be prevented.

The present invention has been made in consideration of the above circumstances, and in one embodiment, an object of the present invention is to provide a metal resin composite electromagnetic shielding material that has high formability, that is, is capable of conforming to irregularities of 5 mm or more.

As a result of careful investigation, the present inventor has found that a metal resin composite electromagnetic shielding material whose VFL (Value of Forming Limit) calculated from specific parameters satisfies certain conditions has

2

high formability, can be formed into a continuous body, and is particularly capable of conforming to irregularities of 5 mm or more. The present invention has been completed based on the above findings, and is exemplified as below.

[1] A metal resin composite electromagnetic shielding material comprising N (where N is an integer of 1 or more) metal layers and M (where M is an integer of 1 or more) resin layers laminated together, wherein a VFL (Value of Forming Limit) calculated from the following formula satisfies VFL > 0.24.

## [Formula 1]

$$VFL = \sqrt{\varepsilon_1^2 + \varepsilon_2^2}$$

[2] The metal resin composite electromagnetic shielding material according to [1], wherein an apparent conductance C satisfies $C = \sigma \times d > 1.0 \times 10^{-11}$ (S), where $\sigma$ (S/m) is an electrical conductivity of the metal layer and d (m) is a total thickness of the metal layer.

[3] The metal resin composite electromagnetic shielding material according to [1] or [2], wherein each metal layer has a thickness of 4 to 100 $\mu$m.

[4] The metal resin composite electromagnetic shielding material according to any one of [1] to [3], wherein each resin layer has a thickness of 4 to 600 $\mu$m.

[5] The metal resin composite electromagnetic shielding material according to any one of [1] to [4], wherein a total thickness of the metal layers is 15 to 150 $\mu$m.

[6] A covering material or exterior material for an electrical or electronic device, comprising the metal resin composite electromagnetic shielding material according to any one of [1] to [5].

[7] An electric or electronic device, comprising the covering material or exterior material according to [6].

According to one embodiment of the present invention, it is possible to provide a metal resin composite electromagnetic shielding material having high formability.

## BRIEF DESCRIPTION OF THE DRAWINGS

FIG. 1 is a diagram explaining a method for evaluating the forming limit in accordance with ISO-12004-2-2008.

FIG. 2 is a diagram showing the deformation angle after deformation and the distance between markings.

FIG. 3 is a diagram showing a method for calculating the maximum strain $\varepsilon_1$ and minimum strain $\varepsilon_2$ required to calculate VFL.

FIG. 4 is a diagram showing an example of a crack penetrating a metal layer.

## DETAILED DESCRIPTION OF THE INVENTION

Hereinafter, embodiments of the present invention will now be described in detail. It should be understood that the present invention is not intended to be limited to the following embodiments, and any change, improvement or the like of the design may be appropriately added based on ordinary knowledge of those skilled in the art without departing from the spirit of the present invention.

(1. Metal Layer)

There is no particular limitation on the material of the metal layer constituting the metal resin composite electromagnetic shielding material according to one embodiment of the present invention. However, it is preferable that an apparent conductance C satisfy $C = \sigma \times d > 1.0 \times 10^{-11}$ (S), where $\sigma$ (S/m) is the electrical conductivity of the metal layer of the metal resin composite electromagnetic shielding material and d (m) is the total thickness of the metal layer. When a plurality of metal layers is provided, it is preferable that the apparent conductance C satisfy $C = \Sigma \sigma_N \times d_N > 1.0 \times 10L$ (S), where $\sigma_N$ (S/m) is the electrical conductivity of each layer and d (m) is the thickness of each layer. By satisfying this requirement, a high shielding performance is ensured as a metal resin composite electromagnetic shielding material.

In this specification, electrical conductivity is measured based on the four-probe method defined in JIS K 7194.

The surface of the metal layer may be formed with various surface treatment layers for the purposes of adhesion promotion, environmental resistance, heat resistance, rust prevention, and the like. For example, in order to enhance the environmental resistance and heat resistance required when the metal surface is the outermost layer, Au plating, Ag plating, Sn plating, Ni plating, Zn plating, Sn alloy plating (Sn-Ag, Sn-Ni, Sn-Cu, and the like), chromate treatment, and the like can be applied. These treatments may be combined. From the viewpoint of cost, Sn plating or Sn alloy plating is preferred. In addition, for the purpose of improving the adhesion between the metal layer and the resin layer, or between the metal layers themselves, chromate treatment, roughening treatment, Ni plating, and the like may be performed. These treatments may be combined. The roughening treatment is preferable because it is easier to obtain adhesion. In addition, in order to improve the shielding performance against a DC magnetic field, a metal plating having a high relative magnetic permeability may be provided. Examples of metal plating with high relative magnetic permeability include Fe-Ni alloy plating and Ni plating.

When using copper foil, it is preferable to use one with high purity since this improves shielding performance. The purity is preferably 99.5% by mass or more, and more preferably 99.8% by mass or more. As the copper foil, rolled copper foil, electrolytic copper foil, metallized copper foil, and the like can be used, but rolled copper foil, which has excellent flexibility and formability (formability includes drawing formability, the same applies below), is preferred. When alloy elements are added to copper foil to produce a copper alloy foil, the total content of these elements and unavoidable impurities is preferably less than 0.5% by mass. In addition, it is preferable that the copper foil contains at least one selected from the group consisting of Sn, Mn, Cr, Zn, Zr, Mg, Ni, Si, and Ag in a total amount of 50 to 2000 ppm by mass, and/or P in a total amount of 10 to 50 ppm by mass, since this improves the extensibility compared to a pure copper foil of the same thickness.

The thickness of each metal layer constituting the metal resin composite electromagnetic shielding material according to one embodiment of the present invention is preferably 4 $\mu$m or more. If the thickness is 4 $\mu$m or more, it is possible to avoid difficulty in handling, and it is possible to prevent a significant decrease in the ductility of the metal layer and insufficient formability of the laminate. Further, if the thickness of each layer is less than 4 $\mu$m, a large number of metal layers must be laminated in order to obtain a good electromagnetic wave shielding performance, which causes a problem of increased manufacturing costs. From this viewpoint, the thickness of each metal layer is more preferably 10 $\mu$m or more, even more preferably 12 $\mu$m or more, and even more preferably 15 $\mu$m or more. On the other hand, if the thickness of each layer exceeds 100 $\mu$m, formability may be deteriorated, so the thickness of each layer is preferably 100 $\mu$m or less, more preferably 50 $\mu$m or less, even more preferably 45 $\mu$m or less, and even more preferably 40 $\mu$m or less. The thickness of the metal layer can be measured, for example, using a constant pressure thickness tester (THICKNESS METER B-1, manufactured by Toyo Seiki Seisaku-sho, Ltd.) in accordance with Method A of JIS K 6250: 2019, and can be obtained by averaging the measured values at four points on the sheet sample surface. In addition, the measurement can be performed with an indenter having a diameter of 5 mm and a pressure of 1.22 N. If the thickness of a metal layer in a laminate is to be measured, the thickness cross section can be observed with a SEM or the like to measure the thickness.

The metal resin composite electromagnetic shielding material may include a single metal layer. However, from the viewpoint of improving formability and shielding performance, the metal resin composite electromagnetic shielding material preferably includes a plurality of metal layers laminated together with a resin layer interposed therebetween, and from the viewpoint of ensuring excellent electromagnetic shielding properties while reducing the total thickness of the metal resin composite electromagnetic shielding material, it is more preferable to laminate two or more metal layers with a resin layer interposed therebetween. By laminating two or more metal layers with a resin layer interposed therebetween, the shielding performance is significantly improved compared to when the metal layer is a single layer or when two metal layers are laminated without a resin layer interposed therebetween, even if the total thickness of the metal layers is the same. Although the shielding performance can be improved by directly laminating the metal layers on top of each other due to an increase in the total thickness of the metal layers, in order to obtain a significant improvement, it is preferable to laminate the metal layers via a resin layer. In other words, by laminating a plurality of metal layers that make up the laminate with resin layers interposed therebetween, the total thickness of the metal layers required to obtain the same electromagnetic wave shielding performance can be reduced, making it possible to achieve both a lightweight laminate and an electromagnetic wave shielding performance. In addition, in this case, it is only necessary that the metal layers are not directly overlapped with each other, and it is also laminate a part or all the resin layers in a overlapping manner. Of course, it is also possible to arrange the metal layers and the resin layers in an alternating manner, one by one.

This is believed to be because the presence of the resin layer between the metal layers increases the number of times that electromagnetic waves are reflected, resulting in attenuation of the electromagnetic waves. However, although the electromagnetic shielding properties improve with an increase in the number of metal layers, increasing the number of layers increases the number of lamination processes, which leads to increased manufacturing costs, and the shielding improvement effect also tends to saturate. Therefore, the number of metal layers constituting the metal resin composite electromagnetic shielding material is preferably 5 or less, more preferably 4 or less, and even more preferably 3 or less.

In one embodiment of the present invention, when multiple metal layers are formed, all the metal layers may be made of the same material, or different materials may be used for each layer. In addition, all the metal layers may have the same thickness, or the thickness may differ for each layer.

Therefore, in the metal resin composite electromagnetic shielding material according to one embodiment of the present invention, the total thickness of all the metal layers can be 15 to 150 $\mu$m, or can be 100 $\mu$m or less, 80 $\mu$m or less, or 60 $\mu$m or less.

(2. Resin Layer)

In one embodiment of the metal resin composite electromagnetic shielding material according to the present invention, by sandwiching a resin layer between metal layers, a significant improvement in the electromagnetic shielding performance is obtained by laminating a plurality of metal layers. Although the shielding performance is improved by directly stacking the metal layers on top of each other due to an increase in the total thickness of the metal layers, in order to obtain a significant improvement, it is preferable to laminate the metal layers via a resin layer. This is believed to be because the presence of the resin layer between the metal layers increases the number of times that electromagnetic waves are reflected, resulting in attenuation of the electromagnetic waves.

A resin layer having a large impedance difference with the metal layer is preferable in terms of obtaining an excellent electromagnetic wave shielding performance. In order to produce a large impedance difference, it is necessary that the resin layer has a small relative permittivity, and specifically, it is preferably 10.0 or less (value at 20 °C; the same applies below), more preferably 5.0 or less, and even more preferably 3.5 or less. In principle, the relative permittivity cannot be smaller than 1.0. For commonly available materials, the lowest is around 2.0, and even if the relative permittivity is lowered further to approach 1.0, the increase in shielding performance is limited, while the material itself becomes specialized and expensive. Considering the balance between cost and function, the relative permittivity is preferably 2.0 or more, and more preferably 2.2 or more.

Specifically, from the viewpoint of formability, a synthetic resin is particularly preferred as a material for forming the resin layer. The resin layer may contain fiber reinforcing materials such as carbon fiber, glass fiber, and aramid fiber. From the viewpoint of improving the shielding performance, a magnetic material may be mixed into the resin layer as long as it does not adversely affect the present invention. As for synthetic resins, from the standpoint of ease of availability and formability, mention can be made to polyesters such as PET (polyethylene terephthalate), PEN (polyethylene naphthalate) and PBT (polybutylene terephthalate); olefin resins such as polyethylene and polypropylene; polyamide, polyimide, liquid crystal polymer, polyacetal, fluororesin, polyurethane, acrylic resin, epoxy resin, silicone resin, phenolic resin, melamine resin, ABS resin, polyvinyl alcohol, urea resin, polyvinyl chloride, polycarbonate, polystyrene, styrene butadiene rubber, and the like. Among these, PET, PEN, polyamide and polyimide are preferred for reasons of moldability and cost. The synthetic resin may be an elastomer such as urethane rubber, chloroprene rubber, silicone rubber, fluororubber, styrene-based, olefin-based, vinyl chloride-based, urethane-based, amide-based, and the like. The resin layers used in the metal resin composite electromagnetic shielding material according to one embodiment of the present invention may all be made of the same resin material, or different resin materials may be used for each layer. From the viewpoint of formability, it is preferable that some or all of the resin layers are insulating layers.

The resin material can be laminated in the form of a film or fiber. The resin layer can also be formed by applying an uncured resin composition to the metal layer and then curing it, but it is preferable to form a resin film that can be attached to the metal layer for ease of production. In particular, a PET film can be preferably used. In particular, by using a biaxially stretched film as the PET film, the strength of the shielding material can be increased.

The thickness of the resin layer is not particularly limited. However, if the thickness per layer is less than 4 $\mu$m, the breaking strain (extensibility) of the shielding material tends to decrease. Therefore, the thickness of each resin layer is preferably 4 $\mu$m or more, more preferably 7 $\mu$m or more, even more preferably 9 $\mu$m or more, even more preferably 10 $\mu$m or more, even more preferably 20 $\mu$m or more, even more preferably 40 $\mu$m or more, even more preferably 80 $\mu$m or more, and even more preferably 100 $\mu$m or more. On the other hand, even if the thickness per sheet exceeds 600 $\mu$m, the breaking strain (extensibility) of the shielding material tends to decrease. Therefore, the thickness of each resin layer is preferably 600 $\mu$m or less, more preferably 500 $\mu$m or less, even more preferably 400 $\mu$m or less, even more preferably 250 $\mu$m or less, and even more preferably 200 $\mu$m or less. In one embodiment of the present invention, all of the resin layers may have the same thickness, or the thicknesses of the layers may vary. Here, one resin layer means a portion in which the resin is continuous without any metal layer interposed therebetween. For example, even when a plurality of resin films is continuously laminated in the manufacturing process of the electromagnetic wave shielding material, since there is no metal layer between these films and they appear to be one continuous body, they are regarded as one resin layer. The thickness of the resin layer can be measured by the same method as the method for measuring the thickness of the metal layer described above.

Generally, resin layers have higher ductility than metal layers, and therefore, by supporting both sides of each metal layer with a resin layer, the ductility of the shielding metal layer is significantly improved, and the formability of the laminate is significantly improved. From the viewpoint of improving moldability, it is preferable to laminate metal layers via a resin layer rather than directly laminating metal layers on each other.

The surface of the resin layer may be subjected to various surface treatments for the purpose of, for example, promoting adhesion with the metal layer. For example, the adhesion between the resin layer and the shielding metal layer can be improved by applying a primer coat or a corona treatment to the surface of the resin layer to be attached to the shielding metal layer.

(3. Electromagnetic Shielding Material)

In one embodiment of the present invention, there is provided metal resin composite electromagnetic shielding material comprising N (where N is an integer of 1 or more) metal layers and M (where M is an integer of 1 or more) resin layers laminated together,

wherein a VFL (Value of Forming Limit) calculated from the following formula satisfies VFL > 0.24.

## [Formula 2]

$$\text{VFL} = \sqrt{\varepsilon_1^2 + \varepsilon_2^2}$$

There are no particular limitations on N as long as it is an integer of 1 or more, and a higher electromagnetic wave shielding performance can be obtained by increasing N. However, as described above, N is typically 1, 2, 3, 4, or 5.

Although M is not particularly limited as long as it is an integer of 1 or more, in order to sandwich the resin layer between metal layers and improve the electromagnetic wave shielding performance, M is typically M = N+1, M = N-1, or M = N. From the viewpoint of earth connection or the like, it is preferable that at least one of the outermost layers is a metal layer.

Hereinafter, the method for calculating VFL will be described in detail below. The inventors have found that the larger the VFL calculated from the above formula, the higher the formability.

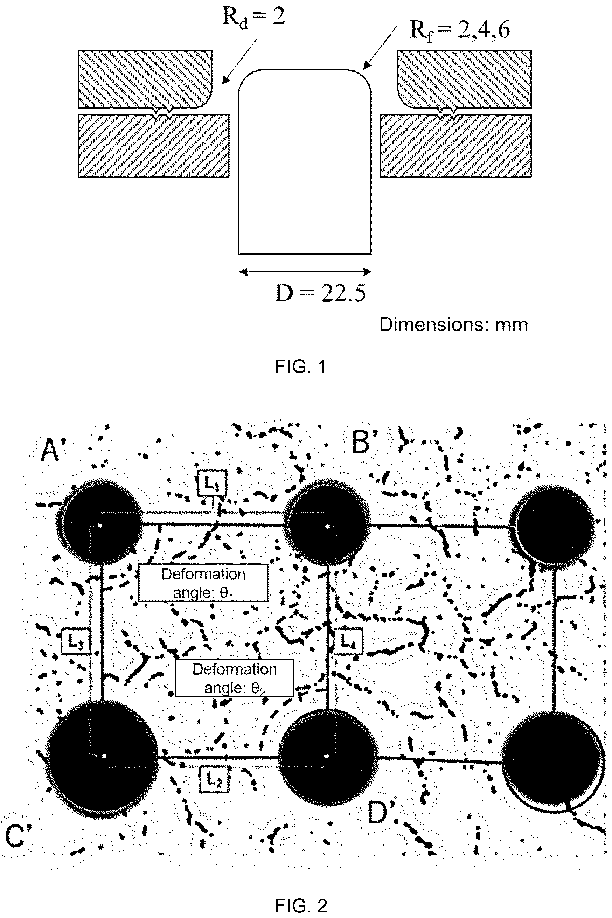

The forming limit is evaluated using a mold for FLD (forming limit diagram) (FIG. 1). The mold is designed by reducing the size specified in ISO-12004-2-2008 by 25%. The punch dimensions are D = 22.5 mm, R part $R_f$ = 2 mm, 4 mm or 6 mm. The die R part $R_d$ = 2 mm. The clearance between the punch and the die is 2.25 mm. The blank holder is provided with a W-shaped notch, and the initial pressure applied to the mold is set to 4000 N to prevent the test piece from being pulled in during forming. When setting the test piece, a drive plate is sandwiched between the test piece and the stripper plate to reduce the effects of material and friction. The driving plate may be Nitoflon No. 900UL (thickness 0.05 mm) manufactured by Nitto Denko Corporation. The driving plate has an outer diameter of φ60 mm and a hole of φ2 mm in the center. A circular test piece having a diameter of φ60 mm is cut out, and a grid pattern of markings with a pitch of 1 mm is applied near the center. The test piece is formed by increasing the punch extrusion depth by 0.5 mm at a time. Three test pieces (n = 3) are prepared for each depth, and any four cells of the grid near the center of each test piece are observed under a microscope. The punch extrusion depth at which cracks penetrating the metal layer are observed in 50% or more (that is, in 6 or more of a total of 12 observation points) is recorded. Then, the size ($L_1$, $L_2$, $L_3$, $L_4$) and deformation angle ($\theta_1$, $\theta_2$) of each cell at the punch extrusion depth are measured with a microscope (FIG. 2).

Next, for the four cells of each test piece, the average length and average deformation angle $\bar{\theta}$ of the mass after deformation are calculated according to the following formula:

[Formula 3]

$$\text{Average length } \overline{A'B'} = \frac{L_1 + L_2}{2}$$

[Formula 4]

$$\text{Average length } \overline{A'C'} = \frac{L_3 + L_4}{2}$$

[Formula 5]

$$\text{Average deformation angle } \overline{\theta} = \frac{\theta_1 + \theta_2}{2}$$

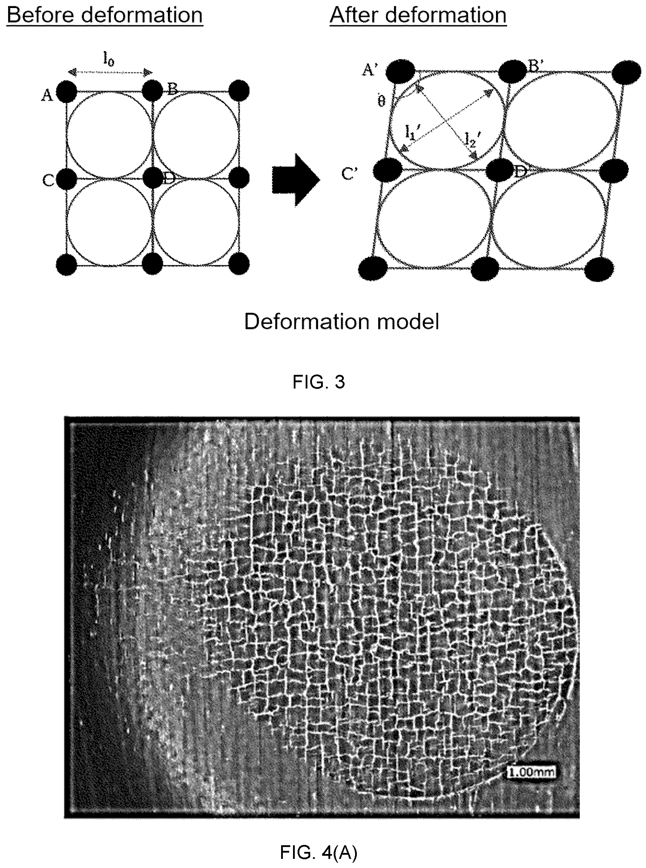

Next, referring to FIG. 3, true strains $\varepsilon_1$ and $\varepsilon_2$ corresponding to the maximum and minimum strains in the cell are calculated based on the average length and average deformation angle.

The calculation procedure for $\varepsilon_1$ and $\varepsilon_2$ is as follows.
First, assuming

[Formula 6]

$$\text{n} = \frac{\overline{A'B'}}{2} \qquad \text{h} = \overline{A'C'} \sin\overline{\theta} \qquad \text{m} = \tan\overline{\theta}$$

the ellipse inscribed in the transformed parallelogram is expressed as follows:

[Formula 7]

$$\alpha x^2 + 2\beta xy + \gamma y^2 = 1 \quad (※) \quad \left( \alpha = \frac{1}{n^2}, \beta = -\frac{1}{n^2 m^2}, \gamma = -\frac{h^2 + 4mn}{n^2 m^2 h^2} \right)$$

When the above "※" is converted from Cartesian coordinates (x, y) to polar coordinates (r, φ),

[Formula 8]

$$f(\varphi) = \alpha \cos^2\varphi + \beta \sin 2\varphi + \gamma\varphi \quad (f(\varphi) = \frac{1}{r^2})$$

is established.

The φ for which f(φ) is maximum and minimum satisfies (df(φ)) / dφ = 0, so by solving (df(φ)) / dφ = 0, it is possible to obtain the following φ:

**[Formula 9]**

$$\varphi_{1,2} = -\frac{\eta}{2}, \frac{\pi - \eta}{2} \quad \left( \sin\eta = \frac{2\beta}{\sqrt{(\gamma - \alpha)^2 + 4\beta^2}} \right)$$

When $l_1'$ and $l_2'$ are calculated from $\varphi_{1,2}$, the result is as follows.

**[Formula 10]**

$$l_1' = 2\sqrt{\frac{1}{f(\varphi_1)}} \qquad l_2' = 2\sqrt{\frac{1}{f(\varphi_2)}}$$

$l_1'$ and $l_2'$ indicate the maximum and minimum diameters of the ellipse.
Using the cell spacing $l_0$ and $l_1'$ and $l_2'$, the true strain is expressed as follows:

**[Formula 11]**

$$\varepsilon_1 = ln\{(l_1' - l_0) + 1\}, \varepsilon_2 = ln\{(l_2' - l_0) + 1\}$$

The larger of the calculated values is the maximum strain, and the smaller is the minimum strain.
Finally, the maximum depth d at which the crack penetrating the metal layer becomes less than 50% is defined as the forming limit, and the VFL (Value of Forming Limit) for each mass is calculated using the following formula. In order to reduce measurement variation, the VFLs calculated for each mass were averaged to determine the VFL of the test piece.

**[Formula 12]**

$$VFL = \sqrt{\varepsilon_1^2 + \varepsilon_2^2}$$

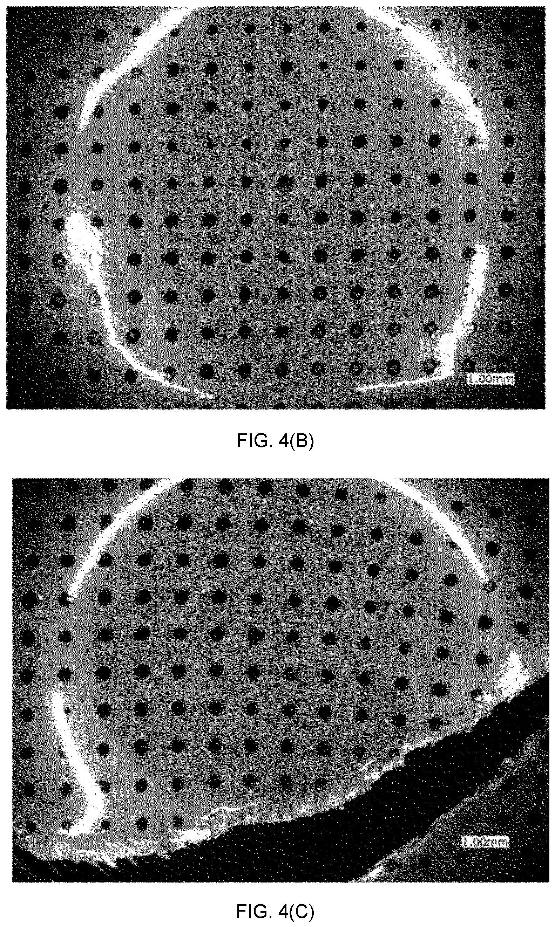

In addition, when the metal layer is the outermost layer (FIG. 4(A)), a crack penetrating a metal layer means a crack penetrating the outermost metal layer. When the metal layer is not the outermost layer but is covered with a resin layer, this means that after the resin layer is peeled off, a crack penetrating the inner metal layer closest to the resin layer is confirmed (FIG. 4(B)). When both the resin layer and the metal layer are cracked, even if no cracks have occurred in the metal layer in the four observed cell, it is deemed that there are cracks penetrating the metal layer in all of the cells (FIG. 4(C)).
When the VFL calculated by the above procedure exceeds 0.24, it was found that the molding limit of the metal resin composite electromagnetic shielding material is 5.0 mm or more, and that the formability is high. Therefore, when the VFL exceeds 0.24, it is possible to form it as a continuous body, and it is possible to conform to irregularities of, for example, 5 mm or more. From this viewpoint, the VFL is preferably 0.26 or more, more preferably 0.28 or more, even more preferably 0.30 or more, even more preferably 0.32 or more, even more preferably 0.34 or more, even more preferably 0.36 or more, even more preferably 0.38 or more, and even more preferably 0.40 or more. The upper limit of VFL is not particularly limited, but may be set to 0.50 or less, for example, from the viewpoint of productivity and cost.
The method for improving the VFL is not particularly limited, but may be, for example, a method for adjusting the thickness of each metal layer or a method for adjusting the elongation of a resin layer.
The metal resin composite electromagnetic shielding material according to each embodiment of the present invention can be used for a variety of electromagnetic shielding applications, particularly as a covering or exterior material for electric / electronic devices (for example, inverters, communication devices, resonators, electron tubes/discharge lamps, electric heating devices, electric motors, generators, electronic components, printed circuits, medical devices, and the like), a covering material for harnesses or communication cables connected to electric/electronic devices, an electromagnetic shielding sheet, an electromagnetic shielding panel, an electromagnetic shielding bag, an electromagnetic shielding box, an electromagnetic shielding room, and the like. Further, it is also possible to perform insert molding using the metal resin composite electromagnetic shielding material according to each embodiment of the present invention as an insert part. Furthermore, in order to improve the electromagnetic wave shielding performance, an electromagnetic wave shielding sheet such as a magnetic sheet can be attached to the inside and/or outside of the metal resin composite electromagnetic wave shielding material of the present invention, as long as it does not affect the present invention.

**EXAMPLES**

Hereinafter, examples of the present invention will be described below together with comparative examples, which are provided for a better understanding of the present invention and its advantages, and are not intended to limit the invention.

As the metal layers, three types of rolled copper foils (when measured from the surface using EBSD (crystal orientation analysis), Type A: crystal grain size is 300 $\mu$m or more; Type B: crystal grain size is 10 $\mu$m or more; Type C: crystal grain size is less than 10 $\mu$m.) and two types of aluminum foils (Type A: A8021 material; Type B: A8021 material annealed at 300 °C for 1 hour) were prepared, and as the resin layers, three types of resins (PET: polyethylene terephthalate film, PE: polyethylene film, PC: polycarbonate film) were prepared. The thickness and conductivity of each type of copper foil, and the thickness of each type of resin are shown in Table 1. In Table 1, a cross in the "Filler" column indicates that no filler was added, and a circle indicates that filler was added to the resin.

For each example, lamination was performed according to the laminate structure shown in Table 1. A urethane adhesive was used as the adhesive for lamination. The order of each layer shown in the laminate structure is the order of lamination. "Resin" means a resin layer, and "Metal" means a metal layer. An adhesive layer is present between each resin layer and each metal layer, but is omitted in Table 1.

(Evaluation of formability)

For each of the Examples and Comparative Examples, the depth of the forming limit was evaluated using the above-mentioned mold for FLD (forming limit diagram), and the VFL was calculated from the amount of strain at that time. As shown in Table 1, in the examples, the depth of forming limit was 5.0 mm or more, and the formability was excellent. In this case, the VFL values were all higher than 0.24. In Table 1, "formability" indicated as a double circle means that the depth of forming limit is 8.5 mm or more, a circle means that the depth of forming limit is 5.0 mm or more and less than 8.5 mm, a triangle means that the depth of forming limit is 4.0 mm or more and less than 5.0 mm, and a cross means that the depth of forming limit is less than 4.0 mm.

(Evaluation of shielding performance)

Then, for each of the Examples and Comparative Examples, the apparent conductance C $=\sigma \times$ d(S) was calculated from the electrical conductivity $\sigma$ (S/m) of the metal layer and the total thickness d (m). The electrical conductivity of the metal layer was determined by the four-probe method described above, and the thickness of the metal layer was measured for each metal layer before lamination with the resin using a constant pressure thickness tester (THICKNESS METER B-1, manufactured by Toyo Seiki Seisaku-sho, Ltd.) by the method described above. In addition, for each of the Examples and Comparative Examples, the magnetic field shielding performance was evaluated at a frequency of 500 kHz under room temperature (25 °C) conditions using a magnetic field measuring tool of a KEC method shielding performance measuring device (JSE-KEC manufactured by Techno Science Co. Ltd.) and a network analyzer (E5080 manufactured by Keysight Technologies). The calculation results of the apparent conductance C and the measurement results of the shielding performance are shown in Table 1. It can be seen that the Examples of the present invention were able to maintain the shielding performance while improving the formability. In addition, in Table 1, "shielding performance" marked with a circle means that the shielding performance is 10 dB or more in the 500 kHz frequency band according to the KEC method, and a cross means that the shielding performance is less than 10 dB in the 500 kHz frequency band according to the KEC method.

Table 1

| | lamination structure | Metal layer | | | | | Resin layer | | | | Punch (mm) | Depth of forming limit (mm) | VFL | Crack condition | Formability | Shielding performance |
| --- | --- | --- | --- | --- | --- | --- | --- | --- | --- | --- | --- | --- | --- | --- | --- | --- |
| | | Type | Thickness (μm) | Total thickness (um) | Conductivity (S/m) | Apparent conductance C (S) | Type | Thickness (μm) | Extensibility | Filler | | | | | | |
| Example 1 | Resin/Metal/Resin/Metal/Resin/-Metal | Cu (Type A) | 18 | 54 | 5.7.E-07 | 3.1.E-11 | PET | 100 | 130% | × | R=6 | 7 | 0.376-3 | Internal foil crack | ○ | ○ |
| Example 2 | Resin/Metal/Resin/Metal/Resin/-Metal | Cu (Type B) | 18 | 54 | 57E-07 | 3.1E-11 | PET | 100 | 130% | × | R=6 | 6 | 0.263-3 | Internal foil crack | ○ | ○ |
| Example 3 | Resin/Metal/Resin/Metal | Cu (Type B) | 35 | 70 | 5.7.E-07 | 4.0E-11 | PET | 100 | 130% | × | R=6 | 6.5 | 0.3113 | Resin crack | ○ | ○ |
| Example 4 | Resin/Metal/Resin/Metal/Resin/-Metal | Cu (Type C) | 18 | 36 | 5.7.E-07 | 2.1.E-11 | PET | 100 | 130% | × | R=6 | 6 | 0.240-3 | Internal foil crack | ○ | ○ |
| Example 5 | Resin/Metal/Resin/Metal/Resin/-Metal | Al (Type A) | 35 | 105 | 4.0.E-07 | 4.2.E-11 | PET | 100 | 130% | × | R=6 | 8.5 | 0.462-8 | External foil crack | ◎ | ○ |
| Example 6 | Resin/Metal/Resin/Metal | Cu (Type B) | 18 | 36 | 5.7.E-07 | 2.1.E-11 | PET | 100 | 130% | × | R=6 | 6.5 | 0.303-8 | Internal foil crack | ○ | ○ |
| Example 7 | Resin/Metal/Resin/Metal/Resin/-Metal | Cu (Type A) | 18 | 54 | 5.7.E-07 | 3.1.E-11 | PET | 25 | 75% | ○ | R=6 | 6 | 0.275-6 | Resin crack | ○ | ○ |
| Example 8 | Resin/Metal/Resin/Metal/Resin/-Metal | Cu (Type A) | 18 | 54 | 5.7.E-07 | 3.1.E-11 | PET | 50 | 126% | ○ | R=6 | 6 | 0.297-5 | Resin crack | ○ | ○ |
| Example 9 | Resin/Metal/Resin/Metal/Resin/-Metal | Al (Type A) | 35 | 105 | 4.0.E-07 | 4.2.E-11 | PET | 100 | 130% | × | R=6 | 10 | 0.579-1 | Resin crack | ◎ | ○ |
| Example 10 | Resin/Metal/Resin/Metal/Resin/-Metal | Cu (Type A) | 18 | 54 | 5.7.E-07 | 3.1.E-11 | PET | 50 | 134% | × | R=6 | 5.5 | 0.246-0 | Internal foil crack | ○ | ○ |
| Example 11 | Resin/Metal/Resin/Metal/Resin/-Metal | Cu (Type C) | 18 | 54 | 5.7.E-07 | 3.1.E-11 | PET | 50 | 134% | × | R=6 | 6 | 0.275-8 | Internal foil crack | ○ | ○ |
| Example 12 | Resin/Metal/Resin/Metal/Resin/-Metal | Cu (Type A) | 18 | 54 | 5.7.E-07 | 3.1.E-11 | PA | 25 | 87% | × | R=6 | 6 | 0.273-0 | Internal foil crack | ○ | ○ |
| Example 13 | Resin/Metal/Resin/Metal/Resin/-Metal | Al (Type A) | 35 | 105 | 4.0.E-07 | 4.2.E-11 | PET | 50 | 126% | ○ | R=6 | 8.5 | 0.479-0 | External foil crack | ◎ | ○ |
| Example 14 | Resin/Metal/Resin/Metal/Resin/-Metal | Al (Type A) | 35 | 105 | 4.0.E-07 | 4.2.E-11 | PET | 25 | 75% | ○ | R=6 | 8.5 | 0.490-9 | External foil crack | ◎ | ○ |

| | lamination structure | Metal layer | | | | | Resin layer | | | | Punch (mm) | Depth of forming limit (mm) | VFL | Crack condi-tion | Formabil-ity | Shielding perfor-mance |
| | | Type | Thick-ness (μm) | Total thick-ness (um) | Conductiv-ity (S/m) | Apparent conduc-tance C (S) | Type | Thickness (μm) | Extensibil-ity | Filler | | | | | | |
| Example 15 | Resin/Metal/Resin/Metal/Resin/-Metal | Al (Type A) | 35 | 105 | 4.0.E-07 | 4.2.E-11 | PET | 50 | 134% | × | R=6 | 8.5 | 0.474-2 | External foil crack | ◎ | ○ |
| Example 16 | Resin/Metal/Resin/Metal/Resin/-Metal | Al (Type A) | 35 | 105 | 4.0.E-07 | 42E-11 | PET | 25 | 121% | × | R=6 | 9 | 0.488-1 | External foil crack | ◎ | ○ |
| Example 17 | Resin/Metal/Resin/Metal/Resin/-Metal | Cu (Type A) | 18 | 54 | 5.7.E-07 | 3.1.E-11 | PET | 25 | 121% | × | R=6 | 6.5 | 0.321-6 | Resin crack | ○ | ○ |
| Example 18 | Resin/Metal/Resin/Metal/Resin/-Metal | Cu (Type A) | 18 | 54 | 5.7.E-07 | 3.1.E-11 | PET | 50 | 134% | × | R=6 | 6 | 0.282-2 | Resin crack | ○ | ○ |
| Example 19 | Resin/Metal/Resin/Metal/Resin/-Metal | Al (Type A) | 35 | 105 | 4 0.E-07 | 4.2.E-11 | PC | 100 | 150% | × | R=6 | 8 | 0.490-4 | External foil crack | ○ | ○ |
| Example 20 | Resin/Metal/Resin | Cu (Type A) | 18 | 18 | 5.7.E-07 | 1.0.E-11 | PC | 100 | 150% | × | R=2 | 7 | 0.414-7 | Internal foil crack | ○ | ○ |
| Example 21 | Resin/Metal/Resin | Cu (Type B) | 35 | 35 | 5.7.E-07 | 2.0.E-11 | PC | 100 | 150% | × | R=4 | 5.5 | 0.344-3 | Internal foil crack | ○ | ○ |
| Example 22 | Resin/Metal/Resin | Cu (Type B) | 35 | 35 | 5.7.E-07 | 2.0.E-11 | PC | 100 | 142% | × | R=6 | 6 | 0.284-0 | Internal foil crack | ○ | ○ |
| Example 23 | Resin/Metal/Resin | Cu (Type B) | 35 | 35 | 5.7.E-07 | 2.0.E-11 | PC | 100 | 31% | × | R=6 | 6 | 02882 | Internal foil crack | ○ | ○ |
| Example 24 | Resin1/Resin2/Metal/Resin1/Resin2/ Metal/Resin1/Resin2/Metal/ | Cu(Type A) | 18 | 54 | 5.7E-07 | 3.1.E-11 | Resin 1: PC Resin 2: PET | Re-sin1:100 Resin 2:25 | 109% | × | R=6 | 6.5 | 0.342-7 | External foil crack | ○ | ○ |

EP 4 611 497 A1

(continued)

| | lamination structure | Metal layer | | | | | Resin layer | | | | Punch (mm) | Depth of forming limit (mm) | VFL | Crack condition | Formability | Shielding performance |
|---|---|---|---|---|---|---|---|---|---|---|---|---|---|---|---|---|
| | | Type | Thickness (μm) | Total thickness (um) | Conductivity (S/m) | Apparent conductance C (S) | Type | Thickness (μm) | Extensibility | Filler | | | | | | |
| Comparative Example 1 | Metal | Cu(Type A) | 12 | 12 | 5.7E-07 | 6.8.E-12 | No resin layer | | | | R=6 | 2.5 | 0.149-0 | Metal foil crack | × | ○ |
| Comparative Example 2 | Metal | Cu(Type B) | 12 | 12 | 5.7.E-07 | 6.8.E-12 | | | | | R=6 | 1 | 0.072-1 | Metal foil crack | × | ○ |
| Comparative Example 3 | Metal | Cu(Type C) | 12 | 12 | 5.7.E-07 | 6.8.E-12 | | | | | R=6 | 05 | 0.047-1 | Metal foil crack | × | ○ |
| Comparative Example 4 | Metal | Cu(Type A) | 18 | 18 | 6.7E-07 | 1.0.E-11 | | | | | R=6 | 3.3 | 0.200-3 | Metal foil crack | × | ○ |
| Comparative Example 5 | Metal | Cu(Type B) | 18 | 18 | 5.7.E-07 | 1.0.E-11 | | | | | R=6 | 1.5 | 0.087-6 | Metal foil crack | × | ○ |
| Comparative Example 6 | Metal | Cu(Type C) | 18 | 18 | 5.7.E-07 | 1.0.E-11 | | | | | R=6 | 1 | 0.056-4 | Metal foil crack | × | ○ |
| Comparative Example 7 | Metal | Cu(Type B) | 35 | 35 | 5.7.E-07 | 2.0.E-11 | | | | | R=6 | 3 | 0.147-4 | Metal foil crack | × | ○ |
| Comparative Example 8 | Metal | Cu(Type C) | 35 | 35 | 5.7.E-07 | 2.0.E-11 | | | | | R=6 | 1.5 | 0.058-3 | Metal foil crack | × | ○ |
| Comparative Example 9 | Metal | Al(Type A) | 35 | 35 | 4.0.E-07 | 1.4.E-11 | | | | | R=6 | 1 | 00399 | Metal foil crack | × | ○ |
| Comparative Example 10 | Metal | Al(Type B) | 35 | 35 | 4.0.E-07 | 1.4.E-11 | | | | | R=6 | 1 | 0.033-6 | Metal foil crack | × | ○ |

EP 4 611 497 A1

(continued)

| lamination structure | Metal layer | | | | | Resin layer | | | | Punch (mm) | Depth of forming limit (mm) | VFL | Crack condition | Formability | Shielding performance |
|---|---|---|---|---|---|---|---|---|---|---|---|---|---|---|---|
| | Type | Thickness (μm) | Total thickness (um) | Conductivity (S/m) | Apparent conductance C (S) | Type | Thickness (μm) | Extensibility | Filler | | | | | | |
| Comparative Example 11 | Resin/Metal/Resin | Cu(Type C) | 18 | 18 | 5.7.E-07 | 1.0.E-11 | PC | 100 | 150% | × | R=2 | 4.5 | 0.222-7 | Internal foil crack | △ | ○ |
| Comparative Example 12 | Resin/Metal/Resin | Cu(Type B) | 35 | 35 | 5.7.E-07 | 2.0.E-11 | PC | 100 | 118% | × | R=6 | 4.5 | 0.191-4 | Internal foil crack | △ | ○ |
| Comparative Example 13 | Resin/Metal | Cu(Type C) | 12 | 12 | 5.7.E-07 | 6.8.E-12 | PET | 100 | 130% | × | R=6 | 3.5 | 0.057-1 | Internal foil crack | × | ○ |
| Comparative Example 14 | Resin/Metal/Resin | Cu(Type C) | 18 | 18 | 5.7.E-07 | 1.0.E-11 | PC | 100 | 150% | × | R=2 | 45 | 0.222-7 | Internal foil crack | △ | ○ |
| Comparative Example 15 | Resin/Metal/Resin | Cu(Type B) | 35 | 35 | 5.7.E-07 | 2.0.E-11 | PC | 100 | 118% | × | R=6 | 4.5 | 0.191-4 | Internal foil crack | △ | ○ |

As can be seen from Table 1, the metal resin composite electromagnetic shielding materials of the examples of the present invention had excellent moldability because they had a VFL of more than 0.24. In addition, the shielding performance was also maintained at a high level. As in Example 24, a plurality of resin films were laminated in succession as the resin layer, but the portions where no metal layer was interposed were combined into one resin layer.

**Claims**

1. A metal resin composite electromagnetic shielding material comprising N (where N is an integer of 1 or more) metal layers and M (where M is an integer of 1 or more) resin layers laminated together,
   wherein a VFL (Value of Forming Limit) calculated from the following formula satisfies VFL > 0.24.

## [Formula 1]

$$\mathrm{VFL} = \sqrt{\varepsilon_1^2 + \varepsilon_2^2}$$

2. The metal resin composite electromagnetic shielding material according to claim 1, wherein an apparent conductance C satisfies $C = \sigma \times d > 1.0 \times 10^{-11}$ (S), where $\sigma$ (S/m) is an electrical conductivity of the metal layer and d (m) is a total thickness of the metal layer.

3. The metal resin composite electromagnetic shielding material according to claim 1 or 2, wherein each metal layer has a thickness of 4 to 100 $\mu$m.

4. The metal resin composite electromagnetic shielding material according to any one of claims 1 to 3, wherein each resin layer has a thickness of 4 to 600 $\mu$m.

5. The metal resin composite electromagnetic shielding material according to any one of claims 1 to 4, wherein a total thickness of the metal layers is 15 to 150 $\mu$m.

6. A covering material or exterior material for an electrical or electronic device, comprising the metal resin composite electromagnetic shielding material according to any one of claims 1 to 5.

7. An electric or electronic device, comprising the covering material or exterior material according to claim 6.

$R_d = 2$

$R_f = 2, 4, 6$

$D = 22.5$

Dimensions: mm

FIG. 1

A'

B'

$L_1$

Deformation angle: $\theta_1$

$L_3$

$L_4$

Deformation angle: $\theta_2$

$L_2$

C'

D'

FIG. 2

Before deformation          After deformation

Deformation model

FIG. 3

FIG. 4(A)

FIG. 4(B)

FIG. 4(C)

## INTERNATIONAL SEARCH REPORT

| International application No. |
| --- |
| **PCT/JP2023/033800** |

**A.  CLASSIFICATION OF SUBJECT MATTER**

*H05K 9/00*(2006.01)i; *B32B 15/08*(2006.01)i; *H01Q 1/52*(2006.01)i
FI:    H05K9/00 W; B32B15/08 N; H01Q1/52

According to International Patent Classification (IPC) or to both national classification and IPC

**B.  FIELDS SEARCHED**

Minimum documentation searched (classification system followed by classification symbols)

B32B15/08; H01Q1/52; H05K9/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
| --- | --- | --- |
| A | JP 2022-91579 A (JX NIPPON MINING & METALS CORP) 21 June 2022 (2022-06-21) entire text, fig. 1-2 | 1-7 |

☐ Further documents are listed in the continuation of Box C.    ☑ See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **24 November 2023** | **05 December 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/033800**

| Patent document cited in search report | | | Publication date (day/month/year) | Patent family member(s) | | | Publication date (day/month/year) |
|---|---|---|---|---|---|---|---|
| JP | 2022-91579 | A | 21 June 2022 | EP | 4262332 | A1 | |
| | | | | entire text, fig. 1-2 | | | |
| | | | | WO | 2022/123864 | A1 | |
| | | | | TW | 202224552 | A | |
| | | | | KR | 10-2023-0088470 | A | |
| | | | | CN | 116547140 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021055113 A
- JP 4811245 B
- JP 2011179162 A